# EUROPEAN PATENT SPECIFICATION

(11) **EP 4 648 092 B1**
(45) Date of publication and mention of the grant of the patent: **30.09.2026**
(21) Application number: 24174875.5
(22) Date of filing: 08.05.2024
(51) Int. Cl.: G06N 10/40, H10W 20/00

(54) **A METHOD FOR CONTACTING THE GATES OF A SPIN QUBIT GATE ARRAY AND CORRESPONDING SPIN QUBIT DEVICE**
VERFAHREN ZUR KONTAKTIERUNG DER GATES EINER SPIN-QUBIT-GATE-ANORDNUNG UND ZUGEHÖRIGE SPIN-QUBIT VORRICHTUNG
PROCÉDÉ DE MISE EN CONTACT DE GRILLES D'UN RÉSEAU DE GRILLES À BITS QUANTIQUES DE SPIN ET DISPOSITIF À BITS QUANTIQUES DE SPIN CORRESPONDANT

(43) Date of publication of application: 12.11.2025
(73) Proprietor: IMEC VZW, 3001 Leuven (BE)
(72) Inventor: CHAN, Boon Teik, 3012 Wilsele (BE); KUBICEK, Stefan, 3212 Pellenberg (BE); WAN, Danny, 3000 Leuven (BE)
(74) Representative: Patent Department IMEC

(56) References cited:
- US-A1- 2023 170 255
- US-B1- 9 502 350
- US-B2- 11 063 138

## Description

### Field of the Invention

The present invention is related to semiconductor spin qubit quantum dot devices comprising an array of gate structures, and in particular to methods for producing electrically conductive contacts to said gate structures.

### State of the art.

Quantum dot devices on semiconductor material have been explored extensively in recent years, as one of the main avenues towards realizing a workable quantum computing chip. Various architectures have been explored, which all have in common the presence of closely spaced gates configured so that quantum dots can be confined underneath one or more of these gates. The gates may for example be metal gates formed on a thin layer of silicon oxide lying on a silicon substrate. By the close spacing of the gates and by applying appropriate voltages to the gates, it is possible to create quantum dots underneath the gates, i.e. small isolated electron or hole islands, and to manipulate qubits associated with the quantum dots. The qubits may for example be defined by the spin state of individual electrons of the quantum dots. Magnetic resonance is used to control the spin states, and a read-out device, for example a single electron transistor, may be integrated in the vicinity of the quantum dot or dots. The quantum dot device is operated at a temperature of Kelvin or sub-Kelvin range (i.e. about 1K or less) in order to enable sufficient qubit coherence times and qubit-based computations.

Due to the small spaces between adjacent gates in the device, contacting the gates by electrically conductive structures is challenging. Traditional damascene-type methods for producing conductive vias and lines are subject to overlay errors having the same order of magnitude as the gate interspacing, leading to unacceptable misalignment errors and risk of shorting.

The patent application publication US 2023/170255 A1 discloses a prior art method of forming spacer-separated self-aligned vias.

### Summary of the invention

The invention is related to a method and a device as disclosed in the appended claims. Throughout this description, the term 'conductive' refers to 'electrically conductive'. An array of gate structures is produced on a planar surface, said array being suitable for the production of a spin qubit quantum dot device. The gate structures include alternately arranged structures of a first and second type, such as plunger gates and barrier gates. According to the invention, electrical connections to the gate structures of the first and second type are produced in separate process step sequences. The connections to the first gate type include the formation of first conductive lines running essentially parallel to the planar surface and connected to the gate structures of the first type by first via connections. Before producing similar connections to the gate structures of the second type, a conformal dielectric layer is formed on the first conductive lines, i.e. on a top surface and on sidewalls of said first conductive lines. The conformal layer is configured, for example in terms of its material and thickness, so that it forms a protective spacer on the sidewalls of the first conductive lines during processing of the second conductive lines, so that shorting between the conductive lines is avoided.

The invention is in particular related to a method for producing electrical connections to a plurality of adjacent gate structures of a spin qubit gate array, the method comprising the steps of :
- producing said gate structures on a planar substrate surface by producing a hardmask layer on a gate layer, patterning the hardmask layer and transferring the patterned hardmask layer to the gate layer, thereby obtaining the adjacent gate structures, with a hardmask portion on each gate structure, wherein the gate structures comprise alternately arranged structures of a first and second type arranged in a longitudinal direction,
- producing first via connections connected to the gate structures of the first type and mutually parallel first conductive lines connected respectively to said first via connections, the first conductive lines running essentially parallel to said planar substrate surface,
- thereafter, producing a conformal dielectric layer on the sidewalls and the top surface of the first conductive lines, said first conductive lines having sidewalls and a top surface. The term 'conformal layer' is defined as a layer that follows the topography of the surface onto which it is deposited. Implicitly, this means that the layer's thickness is suitable for this purpose, i.e. the layer is thin compared to the dimensions of the features defining said topology.
- thereafter, producing second via connections connected to the gate structures of the second type and mutually parallel second conductive lines connected respectively to said second via connections, the second conductive lines running essentially parallel to the planar substrate surface,
wherein the conformal layer forms spacers on the sidewalls of the first conductive lines, said spacers remaining on said sidewalls during the formation of the second conductive lines, so that the conformal layer enables isolating the first conductive lines from the second conductive lines regardless of possible alignment errors between on the one hand the gate structures of the first and second type and on the other hand the respective first and second conductive lines.

According to an embodiment :
- the first via connections and the first conductive lines are produced by :
   ∘ embedding the gate structures and the hardmask portions in a first dielectric layer,
   ∘ planarizing the first dielectric layer,
   ∘ producing first trenches in the first dielectric layer, said first trenches respectively overlapping the gate structures of the first type, so that at least a part of the hardmask portions on the gate structures of the first type is exposed at the bottom of the first trenches,
   ∘ removing at least part of the material of the respective hardmask portions exposed at the bottom of the first trenches, to thereby create first via openings which expose the gate structures of the first type,
   ∘ filling the first via openings and the first trenches with a conductive material, to thereby obtain the first via connections,
   ∘ planarizing said conductive material and the first dielectric layer to thereby obtain the first conductive lines embedded in the planarized first dielectric layer,
- thereafter, the first dielectric layer is recessed until the first conductive lines are lying on top of a recessed surface of the first dielectric layer, said first conductive lines having sidewalls and a top surface,
- the conformal dielectric layer is produced on the recessed surface and on the sidewalls and the top surface of the first conductive lines,
- thereafter, second via connections are produced, connected to the gate structures of the second type and mutually parallel second conductive lines are produced, connected respectively to said second via connections, the second conductive lines running essentially parallel to the planar substrate surface, wherein the second via connections and the second conductive lines are produced by :
   ∘ embedding the first conductive lines including the conformal layer in a second dielectric layer,
   ∘ planarizing the second dielectric layer,
   ∘ producing second trenches in the second dielectric layer, said second trenches respectively overlapping the gate structures of the second type, by removing material of the second dielectric layer using an etch recipe that is selective with respect to the material of the conformal layer,
   ∘ removing the material of the conformal layer from the bottom of the second trenches, while maintaining the conformal layer on the sidewalls of the first conductive lines, thereby forming deepened second trenches, wherein at least a part of the hardmask portions on the gate structures of the second type is exposed at the bottom of the deepened second trenches,
   ∘ removing at least part of the material of the respective hardmask portions exposed at the bottom of the deepened second trenches, thereby creating second via openings which expose the gate structures of the second type,
   ∘ filling the second via openings and the deepened second trenches with an electrically conductive material, to thereby obtain the second via connections,
   ∘ planarizing said electrically conductive material and the second dielectric layer to thereby obtain the second conductive lines embedded in the planarized second dielectric layer.

According to an embodiment, the gate layer is a single layer of gate material so that the mask portions are formed directly on respective gate structures formed uniformly of said gate material.

According to an embodiment, the gate layer comprises a bottom layer formed of a first gate material and a top layer directly on the bottom layer and formed of a second gate material, so that the mask portions are formed directly on respective gate structures formed of a stack of a bottom gate portion of the first gate material and a top gate portion of the second gate material on top of the first gate portion, and :
- the formation of the first via openings includes the removal of at least part of the top gate portions of the gate structures of the first type relative to the bottom gate portions,
- the formation of the second via openings includes the removal of at least part of the hardmask portion) on the gate structures of the second type without removing the top gate portions of the gate structures of the second type.

According to an embodiment, the lateral dimensions of the gate structures and the spacing between adjacent gate structures are between 5 and 50 nm and the thickness of the conformal layer is between 1 and 5 nm.

According to an embodiment, the material of the hardmask portions is silicon nitride, and the conformal layer comprises at least a top layer formed of silicon carbonate.

According to an embodiment, the second gate material is a metal.

The invention is equally related to a spin qubit quantum dot device comprising :
- an array of alternately arranged gate structures of a first and second type arranged in a longitudinal direction on a planar surface,
- first via connections to the gate structures of the first type, said first via connections being connected to respective first conductive lines running essentially parallel to said planar surface,
- second via connections to the gate structures of the second type, said second via connections being connected to respective second conductive lines running essentially parallel to said planar surface,
wherein the first and the second conductive lines are embedded in a layer of dielectric material, said layer comprising spacers on the sidewalls of the first conductive lines.

According to an embodiment of the device, the lateral dimensions of the gate structures and the spacing between adjacent gate structures are between 5 and 50 nm and the thickness of the spacers is between 1 and 5 nm.

### Brief description of the figures

Figures 1 to 18 illustrate key steps in the method according to an embodiment of the invention, illustrating the effect of misalignment and the manner in which the effect thereof are mitigated.
Figures 19 to 29 illustrate the theoretical case wherein no misalignment occurs.
Figures 30 to 37 illustrate an embodiment including gate structures formed of two different materials.

### Detailed description of embodiments of the invention

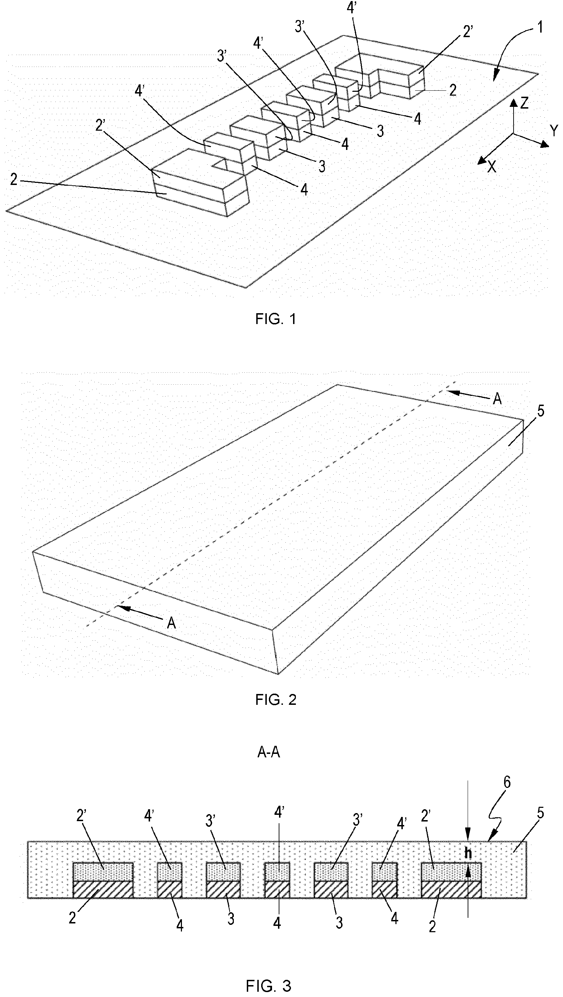

Figure 1 is a schematic representation of an array of structures applicable for the production of a quantum dot device. The array is formed on the surface 1 of a substrate of which the details are not shown, but which may be in accordance with known practice, for example a silicon substrate comprising a silicon oxide layer on its surface, so that the structures of the array are formed directly on the silicon oxide layer, with the aim of creating quantum dots at the interface between the silicon and the silicon oxide. The array includes larger structures 2 at the outer ends, which may for example serve as source and drain-type electrodes in the eventual device, and a row of alternately arranged gate structures 3 and 4 of a first and second type. The function of these latter gate structures in the eventual device will be to enable read and write operations to and from the quantum dots and to separate quantum dots from each other. It is known to refer to these respective gate structures as plunger gates and barrier gates, and this terminology will be used in the present detailed description. So in the presented example, the gate structures of the first type are plunger gates 3 and the gate structures of the second type are barrier gates 4 . However in the broader scope of the appended claims, the meaning of first and second gate structures' may be reversed or the first and second type could refer to other gate types besides barrier and plunger gates.

The exemplary configuration shown in Figure 1 includes two plunger gates 3 separated by a barrier gate 4 between the two plunger gates, while further barrier gates 4 separate the plunger gates 3 from the laterally placed source and drain-type electrodes 2. This is merely an example of a configuration to which the invention is applicable, and the number of gate structures can be higher than shown.

The eventual quantum dot device may also include additional gate structures or electrodes besides the ones shown in Figure 1, such as confinement structures formed of the same material as the gate structures and placed in the vicinity of the gate array. Such additional structures are not shown in the drawing which focuses on the actual array itself. The material of the gates 3,4 and the source and drain-type structures 2 may be any suitable electrically conductive material, such as copper or ruthenium. The invention is not limited to specific dimensions of the various structures, but finds its primary usefulness in relation to very small gate features. For example, the width in the X-direction, as seen with respect to the axis system included in Figure 1, of the plunger gates 3 may be in the order of 10-15 nm, with the width of the barrier gates 4 being somewhat smaller, for example 5-10 nm, and with interspacings between adjacent gates in the order of 5-10 nm. In the orthogonal Y direction, the dimensions may be somewhat larger, so that the gates have rectangular shapes as illustrated. However, other gate shapes are possible (square, rounded, etc), as is known in the art.

It is seen in Figure 1 that the plunger and barrier gates 3,4 and the source and drain-type electrodes 2 are each covered by respective hardmask portions 3',4' and 2' which may be formed of silicon nitride (Si₃N₄, hereafter abbreviated as 'SiN'). The hardmask portions have remained after the formation of the gate structures 3,4 and electrodes 2 by lithography and etching, which includes depositing a hardmask layer on a layer of the gate material, patterning the hardmask layer and transferring the patterned hardmask to the gate layer by etching. Methods for patterning the hardmask and transferring the patterned hardmask features to the gate layer at the small feature sizes described above are known as such and the invention is applicable in combination with any such known methodologies. The invention is in other words applicable to a configuration as shown in Figure 1, obtained by any method known in the art. The thickness of the gates 3,4, and electrodes 2 and of the hardmask portions 2',3',4' may be in the order of a few nanometers, for example between 10 and 50 nm.

With reference to Figure 2 and in the section view along line A-A, shown in Figure 3, the array is first covered by a layer 5 of dielectric material that is subsequently planarized to a planar level extending above and distanced by a distance 'h' from the top of the hardmask portions 2',3',4', wherein said distance h is between 10 and 50 nm for example. Alternatively, layer 5 is planarized down to the hardmask portions 2'-4' which are used as planarization stop surfaces, and a further dielectric layer of the same material and of thickness h is deposited on the planarized surface. The material of layer 5 and (if applicable) of the additionally deposited layer of thickness h may be any dielectric material applicable as an interlayer dielectric (ILD) material in back end of line processing (BEOL), such as silicon oxide. Layer 5 as shown in the drawings is therefore one embodiment of the 'first dielectric layer' referred to in the following method steps stated in the appended claims:
∘ embedding the gate structures (3,4) and the hardmask portions (3',4') in a first dielectric layer (5),
∘ planarizing the first dielectric layer (5),
Based on the above clarifications, it is clear that the 'first dielectric layer' can be a uniform layer formed by one single deposition and then planarized, as well as a layer comprising a first layer that is planarized to the level of the hardmask portions 3',4' and a second planarized layer formed thereon. Also, the step of planarizing the layer is such that the planarized surface is distanced (by distance `h') from the upper surface of the hardmask portions 3',4'.

Planarization steps referred to throughout this description may include grinding steps for thinning a layer, and more finetuned planarization techniques such as chemical mechanical polishing (CMP), applied according to known parameters and recipes.

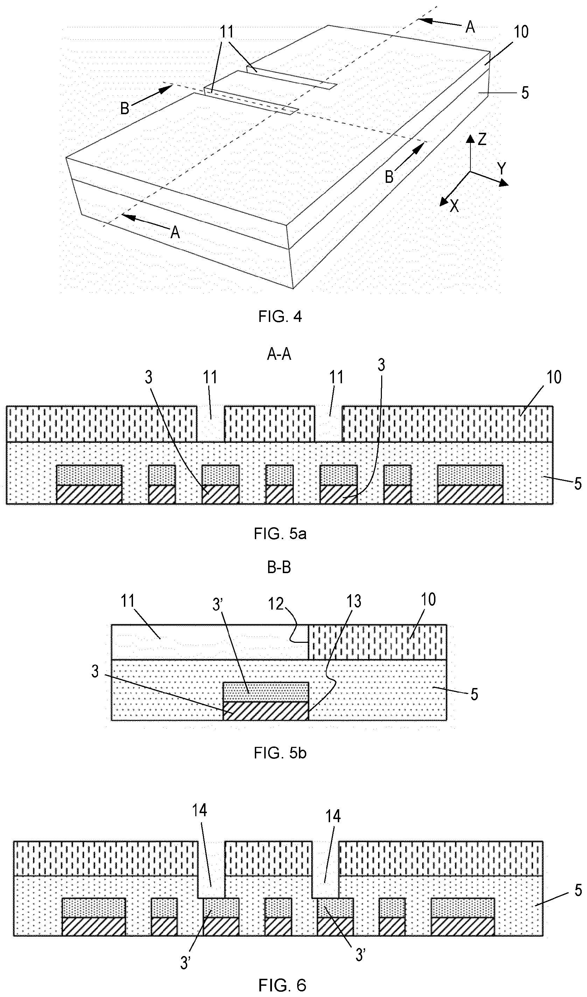

Reference is made to Figure 4, illustrating the deposition and patterning of a hardmask layer 10 on the planarized ILD surface 6, produced by standard lithography and etching techniques. The hardmask 10 could be formed of SiN or any other suitable material. The pattern comprises two trenches 11 positioned respectively above the plunger gates 3 in the manner illustrated in the section views taken along two orthogonal planes AA and BB oriented in the X and Y directions, as shown respectively in Figures 5a and 5b. The width in the X-direction of the trenches 11 is somewhat smaller than the width of the plunger gates 3. The latter is preferable but the trenches 11 may have the same width as the plunger gates 3 or even a somewhat larger width than the plunger gates, as long as the method steps described hereafter are enabled.

In the Y-direction, the trenches have a closed end face 12 that is aligned to the sides 13 of the plunger gates 3. In the X-direction, the trenches are aligned to the plunger gates. However, it is seen that the alignment of the trenches relative to the width of the plunger gates in the X-direction is not perfect and that a misalignment of a few nanometers has occurred. This misalignment is the consequence of an overlay error during the lithography steps applied for producing the patterned hardmask 10. Such overlay errors may be unavoidable, and a misalignment between 0 and about 5 nm must therefore be taken into account. In other words, the centre lines of the trenches 11 could be perfectly aligned to the centrelines of the plunger gates 3, or said centrelines could be shifted relative to each other when there is a misalignment. The invention is configured to enable correctly contacting the plunger and barrier gates 3,4 even when a clearly measurable misalignment has occurred, as in the case illustrated. The way in which this is done will be described in the following paragraphs.

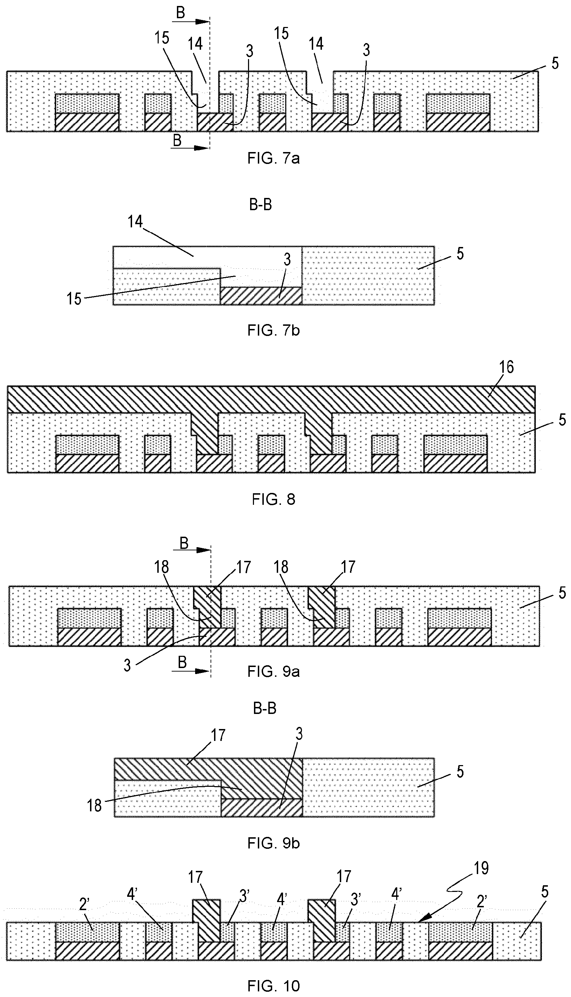

With reference to Figures 6 and 7, the trench pattern of the hardmask 10 is transferred by anisotropic etching to the ILD layer 5, i.e. trenches 14 are formed in said ILD layer 5. The hardmask portions 3' are partly exposed at the bottom of these trenches 14. After stripping the hardmask 10, material of the hardmask portions 3' is removed anisotropically, thereby creating via openings 15 above the plunger gates 3, as visualized in the section views taken again along planes oriented respectively in the X and Y directions in Figures 7a and 7b.

The trenches 14 and via openings 15 are then filled with an electrically conductive material 16, preferably a metal, as illustrated in Figure 8. The metal deposition may possibly be preceded by depositing a seed layer and/or a barrier layer (not shown), as known in the art. The metal 16 is planarized as illustrated in Figures 9a and 9b, thereby creating metal lines 17 running essentially parallel to the substrate surface 1, and connected to the plunger gates 3 by via connections 18.

With reference to Figure 10, the ILD material of layer 5 is then recessed by etching said material back relative to the conductive lines 17, until said lines extend upward from the recessed surface 19. The recessing etchback process stops on the upper surface of the hardmask portions 2',3',4'.

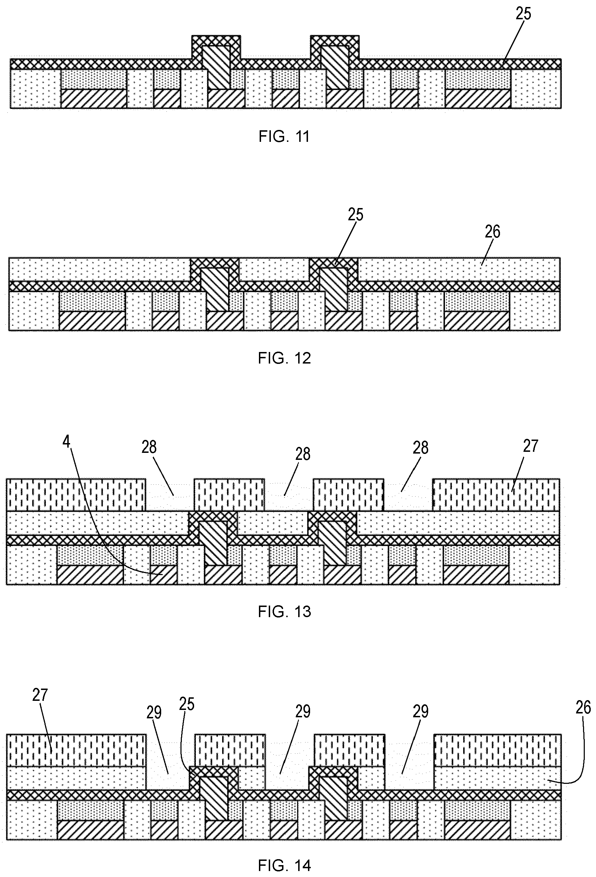

Then a conformal dielectric layer 25 is deposited, as illustrated in Figure 11. The term 'conformal' within the present context is defined as a layer that follows the topography of the surface onto which it is deposited. Implicitly, this means that the layer's thickness is suitable for this purpose, i.e. the layer is thin compared to the dimensions of the features defining said topology, in this case the width and height of the conductive lines 17. The conformal layer thus forms a liner on the sidewalls and upper surfaces of said conductive lines 17 and on the recessed ILD surface 19. The thickness of the conformal layer 25 is for example between 1 and 5 nanometre in the case of the gate dimensions referred to above. The material of the conformal layer 25 is chosen with respect to its functionality as described hereafter, and may for example be silicon carbooxide (hereafter abbreviated as SiCO) or silicon oxycarbonitride (hereafter abbreviated as SiOCN). The conformal layer 25 could also comprise multiple sublayers. For example layer 25 could be a stack of a layer of SiN with a layer of SiCO thereon, or a stack of a layer of SiON (Silicon oxynitride) with a layer of SiOCN thereon. Deposition of these types of layer 25 can be done by known techniques, for example applied in process flows which require similar conformal layer depositions on nano-sized features, such as self-aligned double or multiple patterning methods.

The deposition of the conformal layer 25 is followed by depositing further ILD material 26, and planarizing said material as illustrated in Figure 12, followed by the formation of a further patterned hardmask 27 on the planarized surface, as illustrated in Figure 13. The pattern again comprises trench shapes 28, which are now aligned to the barrier gates 4. The width of the trenches 28 may be somewhat larger than the width of the respective barrier gates 4 as shown in the drawings, but the trenches 28 could have the same or smaller width compared to the barrier gates 4. Again, a degree of misalignment in the X-direction has occurred, as illustrated by the fact that the centre lines of the trenches 28 are shifted over a few nanometres with respect to the centre lines of the barrier gates 4.

With reference to Figure 14, the hardmask 27 is transferred to the underlying ILD layer 26, i.e. trenches 29 are formed in the ILD material by etching anisotropically at the trench positions. Due to the misalignments, it is seen that the trenches 28 in the hardmask 27 are partly overlapping the conformal layer 25 formed on the sidewalls of the conductive lines 17. The etch process for removing the ILD material is selective with respect to said conformal layer 25 so that the latter is essentially not removed by said etch process.

In the case of the misaligned conductive lines 17, this selectiveness has the effect of a self-aligning function of the conformal layer 25 formed on the sidewalls of said misaligned lines 17 : at the right-hand side of the trenches 29 formed in the ILD layer 26, these trenches 29 are effectively aligned to the conformal layers rather than to the trenches 28 defined in the hardmask 27. This self-aligning function will ensure that no shorting occurs between adjacent conductive lines in the eventual device, as described further in this text.

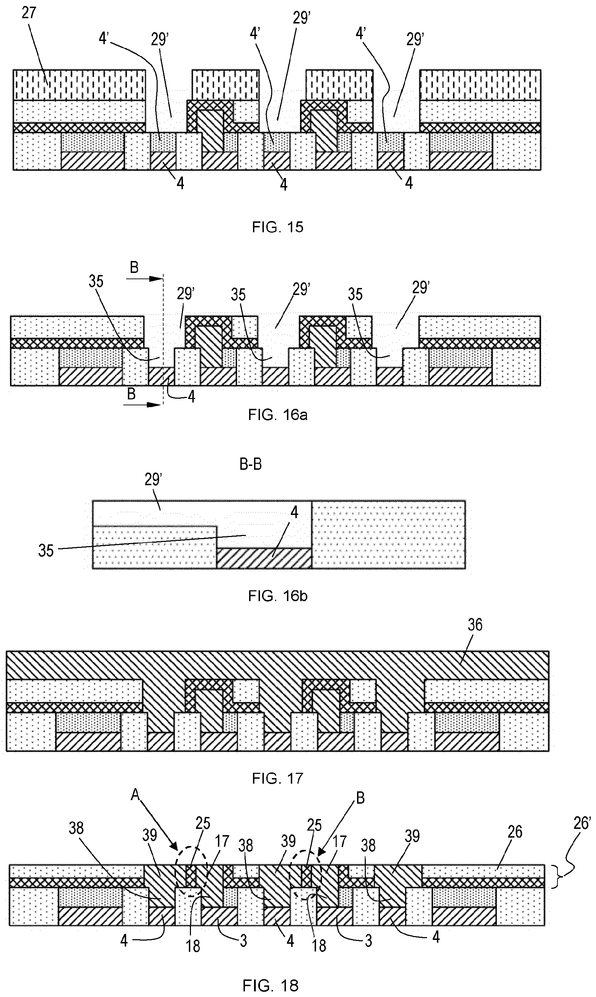

Even though the material of the conformal layer 25 is not removed during etching of the ILD material 26, at the bottom of the trenches 29, the material of the conformal layer 25 needs to be removed, whilst still preserving the conformal layer 25 on the sidewalls of the conductive lines 17. Removal of the conformal layer 25 from the bottom of the trenches 29 is therefore done by a specific etch recipe configured to remove only material from horizontal level surfaces, and not from vertical surfaces. These types of plasma etch recipes are well-known in the art and applied in the above-referenced double or multiple patterning process flows for creating side spacers. The application of this etch recipe leads to the situation shown in Figure 15 : trenches 29' are formed above the respective barrier gates 4, with the hardmask portions 4' exposed at the bottom of the trenches 29'. The trenches 29' are deepened with respect to the trenches 29 and are therefore referred to as 'deepened trenches' in the appended claims.

The hardmask portions 4' are then removed by an etch process that is selective relative to the material of the conformal layer 25. When the hardmask portions 4' are formed of SiN, this means that the material of the conformal layer 25 can for example be SiCO, or the conformal layer can be a stack of SiN and SiCO.

The removal of the hardmask portions 4' results in the creation of via openings 35 as illustrated in Figures 16a and 16b. The via openings 35 and the trenches 29' are then filled with a metal 36 (Figure 17), that is planarized, as illustrated in Figure 18, creating via connections 38 and conductive lines 39 connected to the barrier gates 4. The planarization removes also the conformal layer 25 on top of the first conductive lines 17, so that a planarized dielectric surface is obtained, with conductive lines embedded therein, including first conductive lines 17 contacting the plunger gates 3 and second conductive lines 39 contacting the barrier gates 4. The lines are isolated from each other by the ILD material of layer 5, and by the material of the conformal layer 25.

It is clear from the preceding description that without the presence of the conformal layer 25, there would be a high risk of shorting between the adjacent conductive lines at locations A and B indicated in Figure 18. In other words, the conformal layer 25 ensures that the conductive lines 17 and 39 are isolated from each other at these locations, despite the misalignment of the respective trench-shaped hardmasks 10 and 27. This explains the functionality of the conformal layer 25. To obtain this result, the material of the conformal layer 25 needs to be chosen such that the ILD material of layers 5 and 26 and the material of the hardmask portions 3' and 4' can be removed selectively with respect to this material.

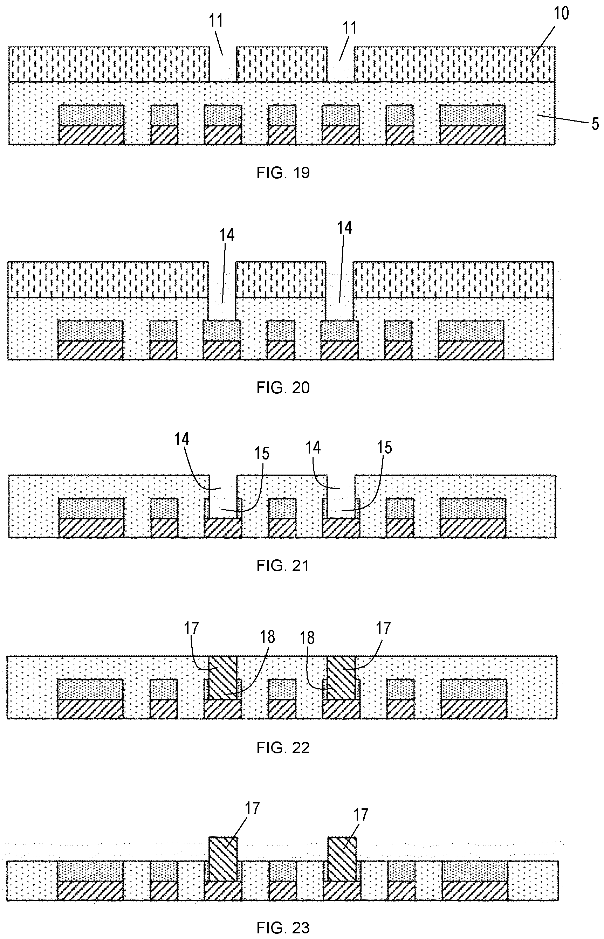

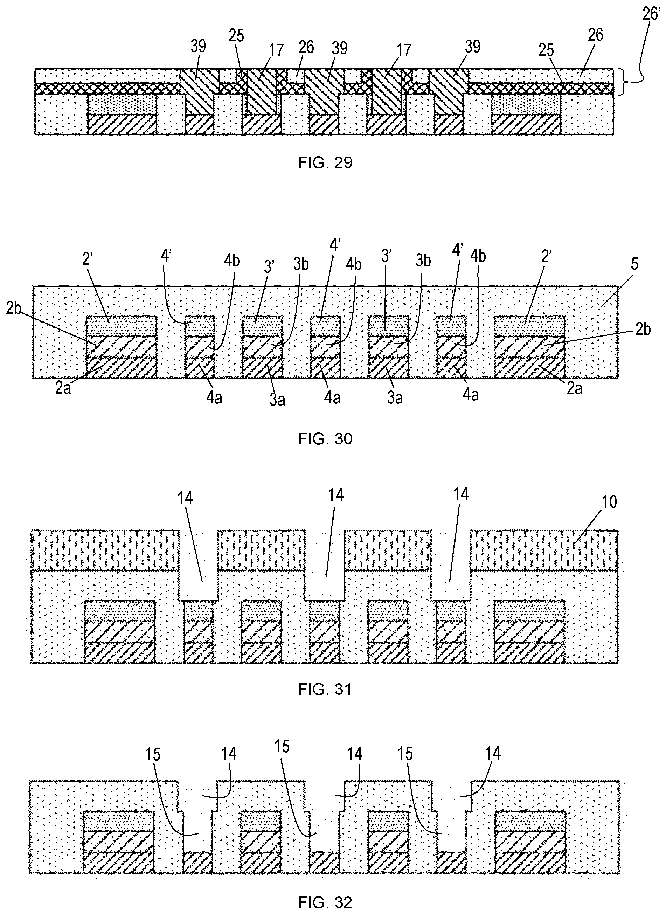

Figures 19 to 29 illustrate the same sequence but now with the trench masks 10 and 27 being perfectly aligned respectively to the widths of the plunger gates 3 and the barrier gates 4. In the image in Figure 29, it is seen that this time, any pair of adjacent conductive lines 17,39 is isolated from each other by ILD material 26 and material of the conformal layer 25. This will be the case also if a very small degree of misalignment occurs. In other words, when the misalignment error is zero or small, the self-aligning function of the conformal layer 25 is not actively applied. However as soon as the misalignment goes beyond a given value, this self-aligning function does come into play as illustrated in Figures 1-18, and this avoids eventual shorting between adjacent lines.

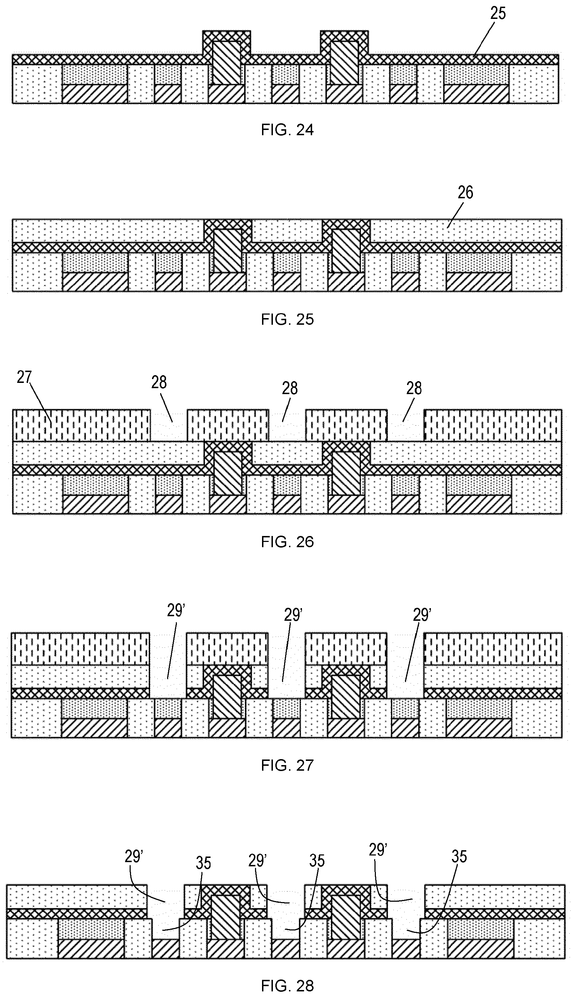

A quantum dot device produced according to the invention comprises gate structures 3,4 of a first and second type with first and second via connections 18,38 and first and second conductive lines 17,39 connected to the respective first and second type gate structures. The device can be recognized by the fact that the first and second conductive lines are embedded in a dielectric layer 26' (as indicated in Figures 18 and 29), said layer comprising spacers on the sidewalls of the first conductive lines 17. The spacers are the portions of the conformal layer 25 remaining on the sidewalls of the first conductive lines 17. In the finished device, the spacers are defined as layers of a dielectric material that is different from the remainder of the dielectric layer 26' that is embedding the first and second conductive lines. Said 'remainder' is the material of layer 26 applied in the steps illustrated in Figures 12 and 25.

A further embodiment is illustrated in Figures 30 to 37. As seen in Figure 30, the initial structures now comprise two metal portions : the plunger gates 3 comprise a bottom portion 3a and a top portion 3b while the barrier gates 4 comprise a bottom portion 4a and a top portion 4b. The bottom and top portions are formed of different metals, for example Wand Ru. In the particular sequence, first trenches 14 are formed above the barrier gates 3, as illustrated in Figure 31, but these first trenches could instead be formed above the plunger gates as in the previous embodiments. The theoretical case is represented of trenches which are perfectly aligned to the barrier gates 3, but a degree of misalignment is possible, as described above.

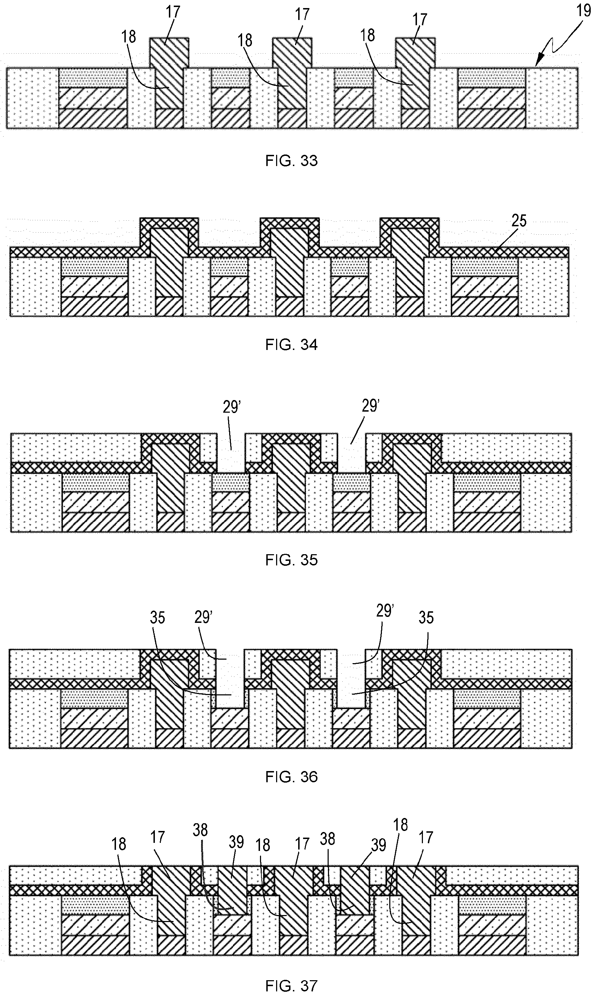

Both the hardmask portions 4' and the top gate portions 4b of the barrier gates are removed at the bottom of the trenches 14, as represented in Figure 32, creating via openings 15 towards the remaining bottom barrier gate portions 4a. This is followed by metal filling and recessing of the ILD material, as illustrated in Figure 33, resulting in first conductive lines 17 lying on top of the recessed ILD surface 19 and connected to the barrier gates by via connections 18. The conformal layer 25 is deposited, as shown in Figure 34, followed (Figure 35) by the formation of a further ILD layer and of trenches 29' formed therein, above the plunger gates 3, and aligned thereto in the case shown, keeping in mind that a degree of misalignment is possible. With reference to Figure 36, the hardmask portions 3' are anisotropically removed at the bottom of the trenches 29', and a second metal fill creates conductive lines 39 and via connections 38 to the top portion 3b of the plunger gates. The two-metal gate structures enable the creation of a level difference between the contacts to the two gate types, which is beneficial in terms of increasing the distance between adjacent gate contacts. Its an advantage that there is less chance of an electrical short between the gate contacts.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A method for producing electrical connections to a plurality of adjacent gate structures (3,4) of a spin qubit gate array, the method comprising the steps of :
- producing said gate structures on a planar substrate surface (1) by producing a hardmask layer on a gate layer, patterning the hardmask layer and transferring the patterned hardmask layer to the gate layer, thereby obtaining the adjacent gate structures (3,4), with a hardmask portion (3',4') on each gate structure, wherein the gate structures comprise alternately arranged structures of a first and second type arranged in a longitudinal direction,
- producing first via connections (18) connected to the gate structures (3) of the first type and mutually parallel first conductive lines (17) connected respectively to said first via connections, the first conductive lines running essentially parallel to said planar substrate surface (1),
- thereafter, producing a conformal dielectric layer (25) on the sidewalls and the top surface of the first conductive lines (17), said first conductive lines (17) having sidewalls and a top surface,
- thereafter, producing second via connections (38) connected to the gate structures (4,3) of the second type and mutually parallel second conductive lines (39) connected respectively to said second via connections, the second conductive lines (39) running essentially parallel to the planar substrate surface (1),
wherein the conformal layer (25) forms spacers on the sidewalls of the first conductive lines (17), said spacers remaining on said sidewalls during the formation of the second conductive lines (39).

2. The method according to claim 1, wherein :
- the first via connections (18) and the first conductive lines (17) are produced by :
∘ embedding the gate structures (3,4) and the hardmask portions (3',4') in a first dielectric layer (5),
∘ planarizing the first dielectric layer (5),
∘ producing first trenches (14) in the first dielectric layer, said first trenches respectively overlapping the gate structures (3,4) of the first type, so that at least a part of the hardmask portions (3',4') on the gate structures of the first type is exposed at the bottom of the first trenches (14),
∘ removing at least part of the material of the respective hardmask portions (3',4') exposed at the bottom of the first trenches, to thereby create first via openings (15) which expose the gate structures (3,4) of the first type,
∘ filling the first via openings (15) and the first trenches (14) with a conductive material (16), to thereby obtain the first via connections (18),
∘ planarizing said conductive material (16) and the first dielectric layer (5) to thereby obtain the first conductive lines (17) embedded in the planarized first dielectric layer (5),
- thereafter, the first dielectric layer (5) is recessed until the first conductive lines (17) are lying on top of a recessed surface (19) of the first dielectric layer (5), said first conductive lines (17) having sidewalls and a top surface,
- the conformal dielectric layer (25) is produced on the recessed surface (19) and on the sidewalls and the top surface of the first conductive lines (17),
- thereafter, second via connections (38) are produced, connected to the gate structures (4,3) of the second type and mutually parallel second conductive lines (39) are produced, connected respectively to said second via connections, the second conductive lines (39) running essentially parallel to the planar substrate surface (1), wherein the second via connections and the second conductive lines are produced by :
∘ embedding the first conductive lines (17) including the conformal layer (25) in a second dielectric layer (26),
∘ planarizing the second dielectric layer (26),
∘ producing second trenches (29) in the second dielectric layer, said second trenches respectively overlapping the gate structures (4,3) of the second type, by removing material of the second dielectric layer (26) using an etch recipe that is selective with respect to the material of the conformal layer (25),
∘ removing the material of the conformal layer (25) from the bottom of the second trenches (29), while maintaining the conformal layer on the sidewalls of the first conductive lines (17), thereby forming deepened second trenches (29'), wherein at least a part of the hardmask portions (4',3') on the gate structures of the second type is exposed at the bottom of the deepened second trenches (29'),
∘ removing at least part of the material of the respective hardmask portions (4',3') exposed at the bottom of the deepened second trenches, thereby creating second via openings (35) which expose the gate structures (4,3) of the second type,
∘ filling the second via openings (35) and the deepened second trenches (29') with an electrically conductive material (36), to thereby obtain the second via connections (38),
∘ planarizing said electrically conductive material and the second dielectric layer (26) to thereby obtain the second conductive lines (39) embedded in the planarized second dielectric layer (26).

3. The method according to claim 1 or 2, wherein the gate layer is a single layer of gate material so that the mask portions (3',4') are formed directly on respective gate structures (3,4) formed uniformly of said gate material.

4. The method according to claim 1 or 2, wherein the gate layer comprises a bottom layer formed of a first gate material and a top layer directly on the bottom layer and formed of a second gate material, so that the mask portions (3',4') are formed directly on respective gate structures formed of a stack of a bottom gate portion (3a,4a) of the first gate material and a top gate portion (3b,4b) of the second gate material on top of the first gate portion, and wherein :
- the formation of the first via openings (15) includes the removal of at least part of the top gate portions (3b,4b) of the gate structures of the first type relative to the bottom gate portions (3a,4a),
- the formation of the second via openings (35) includes the removal of at least part of the hardmask portion (4',3') on the gate structures of the second type without removing the top gate portions (4b,3b) of the gate structures of the second type.

5. The method according to any one of the preceding claims, wherein the lateral dimensions of the gate structures (3,4) and the spacing between adjacent gate structures are between 5 and 50 nm and wherein the thickness of the conformal layer (25) is between 1 and 5 nm.

6. The method according to any one of the preceding claims, wherein the material of the hardmask portions (3',4') is silicon nitride, and wherein the conformal layer (25) comprises at least a top layer formed of silicon carbonate.

7. The method according to any claims 4 to 6 wherein the second gate material is a metal.

8. A spin qubit quantum dot device comprising :
- an array of alternately arranged gate structures (3,4) of a first and second type arranged in a longitudinal direction on a planar surface (1),
- first via connections (18) to the gate structures (3) of the first type, said first via connections being connected to respective first conductive lines (17) running essentially parallel to said planar surface (1),
- second via connections (38) to the gate structures (4) of the second type, said second via connections being connected to respective second conductive lines (39) running essentially parallel to said planar surface (1),
wherein the first and the second conductive lines (17,39) are embedded in a layer (26') of dielectric material, said layer comprising spacers on the sidewalls of the first conductive lines (17).

9. The device according to claim 8, wherein the lateral dimensions of the gate structures (3,4) and the spacing between adjacent gate structures are between 5 and 50 nm and wherein the thickness of the spacers is between 1 and 5 nm.

## Patentansprüche

1. Verfahren zur Herstellung elektrischer Verbindungen zu einer Vielzahl angrenzender Gate-Strukturen (3, 4) eines Spin-Qubit-Gate-Arrays, wobei das Verfahren die folgenden Schritte umfasst:
- Herstellen der Gate-Strukturen auf einer planaren Substratoberfläche (1) durch Herstellen einer Hartmaskenschicht auf einer Gate-Schicht, Strukturieren der Hartmaskenschicht und Transferieren der strukturierten Hartmaskenschicht auf die Gate-Schicht, wodurch die angrenzenden Gate-Strukturen (3, 4) mit einem Hartmaskenabschnitt (3', 4') auf jeder Gate-Struktur erhalten werden, wobei die Gate-Strukturen abwechselnd in einer Längsrichtung eingerichtete Strukturen eines ersten und zweiten Typs umfassen,
- Herstellen erster Durchkontaktierungsverbindungen (18), die mit den Gate-Strukturen (3) des ersten Typs verbunden sind, und zueinander paralleler erster leitfähiger Bahnen (17), die jeweils mit den ersten Durchkontaktierungsverbindungen verbunden sind, wobei die ersten leitfähigen Bahnen im Wesentlichen parallel zu der planaren Substratoberfläche (1) verlaufen,
- anschließendes Herstellen einer konformen dielektrischen Schicht (25) an den Seitenwänden und der oberen Oberfläche der ersten leitfähigen Bahnen (17), wobei die ersten leitfähigen Bahnen (17) Seitenwände und eine obere Oberfläche aufweisen,
- anschließendes Herstellen zweiter Durchkontaktierungsverbindungen (38), die mit den Gate-Strukturen (4, 3) des zweiten Typs verbunden sind, und zueinander paralleler zweiter leitfähiger Bahnen (39), die jeweils mit den zweiten Durchkontaktierungsverbindungen verbunden sind, wobei die zweiten leitfähigen Bahnen (39) im Wesentlichen parallel zu der planaren Substratoberfläche (1) verlaufen,
wobei die konforme Schicht (25) Abstandshalter an den Seitenwänden der ersten leitfähigen Bahnen (17) bildet, wobei die Abstandshalter während des Bildens der zweiten leitfähigen Bahnen (39) an den Seitenwänden verbleiben.

2. Verfahren nach Anspruch 1, wobei:
- die ersten Durchkontaktierungsverbindungen (18) und die ersten leitfähigen Bahnen (17) hergestellt werden durch:
- Einbetten der Gate-Strukturen (3, 4) und der Hartmaskenabschnitte (3', 4') in einer ersten dielektrischen Schicht (5),
- Planarisieren der ersten dielektrischen Schicht (5),
- Herstellen erster Gräben (14) in der ersten dielektrischen Schicht, wobei die ersten Gräben jeweils die Gate-Strukturen (3, 4) des ersten Typs derart überlappen, dass mindestens ein Teil der Hartmaskenabschnitte (3', 4') auf den Gate-Strukturen des ersten Typs am Boden der ersten Gräben (14) freigelegt wird,
- Entfernen mindestens eines Teils des Materials der jeweiligen Hartmaskenabschnitte (3', 4'), die am Boden der ersten Gräben freigelegt sind, um dadurch erste Durchkontaktierungsöffnungen (15) zu schaffen, die die Gate-Strukturen (3, 4) des ersten Typs freilegen,
- Füllen der ersten Durchkontaktierungsöffnungen (15) und der ersten Gräben (14) mit einem leitfähigen Material (16), um dadurch die ersten Durchkontaktierungsverbindungen (18) zu erhalten,
- Planarisieren des leitfähigen Materials (16) und der ersten dielektrischen Schicht (5), um dadurch die ersten leitfähigen Bahnen (17) zu erhalten, die in der planarisierten ersten dielektrischen Schicht (5) eingebettet sind,
- anschließendes Vertiefen der ersten dielektrischen Schicht (5), bis die ersten leitfähigen Bahnen (17) auf der Oberseite einer vertieften Oberfläche (19) der ersten dielektrischen Schicht (5) liegen, wobei die ersten leitfähigen Bahnen (17) Seitenwände und eine obere Oberfläche aufweisen,
- Herstellen der konformen dielektrischen Schicht (25) auf der vertieften Oberfläche (19) sowie an den Seitenwänden und der oberen Oberfläche der ersten leitfähigen Bahnen (17),
- anschließendes Herstellen zweiter Durchkontaktierungsverbindungen (38), die mit den Gate-Strukturen (4, 3) des zweiten Typs verbunden sind, und zueinander paralleler zweiter leitfähiger Bahnen (39), die jeweils mit den zweiten Durchkontaktierungsverbindungen verbunden sind, wobei die zweiten leitfähigen Bahnen (39) im Wesentlichen parallel zu der planaren Substratoberfläche (1) verlaufen, wobei die zweiten Durchkontaktierungsverbindungen und die zweiten leitfähigen Bahnen hergestellt werden durch:
- Einbetten der ersten leitfähigen Bahnen (17), beinhaltend die konforme Schicht (25) in einer zweiten dielektrischen Schicht (26),
- Planarisieren der zweiten dielektrischen Schicht (26),
- Herstellen zweiter Gräben (29) in der zweiten dielektrischen Schicht, wobei die zweiten Gräben jeweils die Gate-Strukturen (4, 3) des zweiten Typs überlappen, durch Entfernen von Material der zweiten dielektrischen Schicht (26) unter Verwendung einer Ätzrezeptur, die gegenüber dem Material der konformen Schicht (25) selektiv ist,
- Entfernen des Materials der konformen Schicht (25) von dem Boden der zweiten Gräben (29), während die konforme Schicht an den Seitenwänden der ersten leitfähigen Bahnen (17) erhalten bleibt, wodurch vertiefte zweite Gräben (29') gebildet werden, wobei mindestens ein Teil der Hartmaskenabschnitte (4', 3') auf den Gate-Strukturen des zweiten Typs am Boden der vertieften zweiten Gräben (29') freigelegt wird,
- Entfernen mindestens eines Teils des Materials der jeweiligen Hartmaskenabschnitte (4', 3'), die am Boden der vertieften zweiten Gräben freigelegt sind, wodurch zweite Durchkontaktierungsöffnungen (35) geschaffen werden, die die Gate-Strukturen (4, 3) des zweiten Typs freilegen,
- Füllen der zweiten Durchkontaktierungsöffnungen (35) und der vertieften zweiten Gräben (29') mit einem elektrisch leitfähigen Material (36), um dadurch die zweiten Durchkontaktierungsverbindungen (38) zu erhalten,
- Planarisieren des elektrisch leitfähigen Materials und der zweiten dielektrischen Schicht (26), um dadurch die zweiten leitfähigen Bahnen (39), die in der planarisierten zweiten dielektrischen Schicht (26) eingebettet sind, zu erhalten.

3. Verfahren nach Anspruch 1 oder 2, wobei die Gate-Schicht eine einzige Schicht aus Gate-Material ist, sodass die Maskenabschnitte (3', 4') direkt auf den jeweiligen Gate-Strukturen (3, 4), die gleichmäßig aus dem Gate-Material gebildet sind, gebildet werden.

4. Verfahren nach Anspruch 1 oder 2, wobei die Gate-Schicht eine aus einem ersten Gate-Material gebildete untere Schicht und eine direkt auf der unteren Schicht liegende obere Schicht aus einem zweiten Gate-Material umfasst, sodass die Maskenabschnitte (3', 4') direkt auf jeweiligen Gate-Strukturen gebildet werden, die aus einem Stapel aus einem unteren Gate-Abschnitt (3a, 4a) des ersten Gate-Materials und einem oberen Gate-Abschnitts (3b, 4b) des zweiten Gate-Materials auf dem ersten Gate-Abschnitt gebildet werden, und wobei:
- das Bilden der ersten Durchkontaktierungsöffnungen (15) das Entfernen mindestens eines Teils der oberen Gate-Abschnitte (3b, 4b) der Gate-Strukturen des ersten Typs relativ zu den unteren Gate-Abschnitten (3a, 4a) beinhaltet,
- das Bilden der zweiten Durchkontaktierungsöffnungen (35) das Entfernen mindestens eines Teils des Hartmaskenabschnitts (4', 3') an den Gate-Strukturen des zweiten Typs ohne Entfernen der oberen Gate-Abschnitte (4b, 3b) der Gate-Strukturen des zweiten Typs beinhaltet.

5. Verfahren nach einem der vorstehenden Ansprüche, wobei die lateralen Abmessungen der Gate-Strukturen (3, 4) und die Beabstandung zwischen angrenzenden Gate-Strukturen zwischen 5 und 50 nm liegen und wobei die Dicke der konformen Schicht (25) zwischen 1 und 5 nm liegt.

6. Verfahren nach einem der vorstehenden Ansprüche, wobei das Material der Hartmaskenabschnitte (3', 4') Siliziumnitrid ist, und wobei die konforme Schicht (25) mindestens eine Deckschicht, die aus Siliziumcarbonat gebildet ist, umfasst.

7. Verfahren nach einem der Ansprüche 4 bis 6, wobei das zweite Gate-Material ein Metall ist.

8. Spin-Qubit-Quantenpunkt-Vorrichtung, die umfasst:
- ein Array abwechselnd eingerichteter Gate-Strukturen (3, 4) eines ersten und zweiten Typs, die in einer Längsrichtung auf einer ebenen Oberfläche (1) eingerichtet sind,
- erste Durchkontaktierungsverbindungen (18) zu den Gate-Strukturen (3) des ersten Typs, wobei die ersten Durchkontaktierungsverbindungen mit jeweiligen ersten leitfähigen Bahnen (17) verbunden sind, die im Wesentlichen parallel zu der ebenen Oberfläche (1) verlaufen,
- zweite Durchkontaktierungsverbindungen (38) zu den Gate-Strukturen (4) des zweiten Typs, wobei die zweiten Durchkontaktierungsverbindungen mit jeweiligen leitfähigen Bahnen (39) verbunden sind, die im Wesentlichen parallel zu der ebenen Oberfläche (1) verlaufen,
wobei die ersten und die zweiten leitfähigen Bahnen (17, 39) in einer Schicht (26') aus dielektrischem Material eingebettet sind, wobei die Schicht Abstandshalter an den Seitenwänden der ersten leitfähigen Bahnen (17) umfasst.

9. Vorrichtung nach Anspruch 8, wobei die lateralen Abmessungen der Gate-Strukturen (3, 4) und die Beabstandung zwischen angrenzenden Gate-Strukturen zwischen 5 und 50 nm liegen und wobei die Dicke der Abstandshalter zwischen 1 und 5 nm beträgt.

## Revendications

1. Procédé de production de connexions électriques à une pluralité de structures de grille adjacentes (3, 4) d'un réseau de grilles à qubits de spin, le procédé comprenant les étapes de :
- production desdites structures de grille sur une surface de substrat plane (1) en produisant une couche de masque dur sur une couche de grille, en formant des motifs sur la couche de masque dur et en transférant la couche de masque dur à motifs sur la couche de grille, obtenant ainsi les structures de grille adjacentes (3, 4), avec une portion masque dur (3', 4') sur chaque structure de grille, dans lequel les structures de grille comprennent des structures agencées alternativement d'un premier et d'un second type agencées dans une direction longitudinale,
- production de premières connexions via (18) connectées aux structures de grille (3) du premier type et de premières lignes conductrices (17) mutuellement parallèles connectées respectivement auxdites premières connexions via, les premières lignes conductrices s'étendant essentiellement parallèlement à ladite surface de substrat plane (1),
- par la suite, production d'une couche diélectrique conforme (25) sur les parois latérales et la surface supérieure des premières lignes conductrices (17), lesdites premières lignes conductrices (17) présentant des parois latérales et une surface supérieure,
- par la suite, production de secondes connexions via (38) connectées aux structures de grille (4, 3) du second type et de secondes lignes conductrices (39) mutuellement parallèles connectées respectivement auxdites secondes connexions via, les secondes lignes conductrices (39) s'étendant essentiellement parallèlement à la surface de substrat plane (1),
dans lequel la couche conforme (25) forme des entretoises sur les parois latérales des premières lignes conductrices (17), lesdites entretoises restant sur lesdites parois latérales durant la formation des secondes lignes conductrices (39).

2. Procédé selon la revendication 1, dans lequel :
- les premières connexions via (18) et les premières lignes conductrices (17) sont produites en :
- intégrant les structures de grille (3, 4) et les portions masques durs (3', 4') dans une première couche diélectrique (5),
- planarisant la première couche diélectrique (5),
- produisant des premières tranchées (14) dans la première couche diélectrique, lesdites premières tranchées chevauchant respectivement les structures de grille (3, 4) du premier type, de façon à ce qu'au moins une partie des portions masques durs (3', 4') sur les structures de grille du premier type soit exposée au fond des premières tranchées (14),
- retirant au moins une partie du matériau des portions masques durs (3', 4') respectives exposées au fond des premières tranchées, pour créer ainsi des premières ouvertures via (15) qui exposent les structures de grille (3, 4) du premier type,
- remplissant les premières ouvertures via (15) et les premières tranchées (14) avec un matériau conducteur (16), pour obtenir ainsi les premières connexions via (18),
- planarisant ledit matériau conducteur (16) et la première couche diélectrique (5) pour obtenir ainsi les premières lignes conductrices (17) intégrées dans la première couche diélectrique planarisée (5),
- par la suite, la première couche diélectrique (5) est évidée jusqu'à ce que les premières lignes conductrices (17) se situent sur une surface évidée (19) de la première couche diélectrique (5), lesdites premières lignes conductrices (17) présentant des parois latérales et une surface supérieure,
- la couche diélectrique conforme (25) est produite sur la surface évidée (19) et sur les parois latérales et la surface supérieure des premières lignes conductrices (17),
- par la suite, des secondes connexions via (38) sont produites, connectées aux structures de grille (4, 3) du second type et des secondes lignes conductrices (39) mutuellement parallèles sont produites, connectées respectivement auxdites secondes connexions via, les secondes lignes conductrices (39) s'étendant essentiellement parallèlement à la surface de substrat plane (1), dans lequel les secondes connexions via et les secondes lignes conductrices sont produites en :
- intégrant les premières lignes conductrices (17) incluant la couche conforme (25) dans une seconde couche diélectrique (26),
- planarisant la seconde couche diélectrique (26),
- produisant des secondes tranchées (29) dans la seconde couche diélectrique, lesdites secondes tranchées chevauchant respectivement les structures de grille (4, 3) du second type, en retirant du matériau de la seconde couche diélectrique (26) à l'aide d'une recette de gravure qui est sélective par rapport au matériau de la couche conforme (25),
- retirant le matériau de la couche conforme (25) depuis le fond des secondes tranchées (29), tout en maintenant la couche conforme sur les parois latérales des premières lignes conductrices (17), formant ainsi des secondes tranchées approfondies (29'), dans lequel au moins une partie des portions masques durs (4', 3') sur les structures de grille du second type est exposée au fond des secondes tranchées approfondies (29'),
- retirant au moins une partie du matériau des portions masques durs respectives (4', 3') exposées au fond des secondes tranchées approfondies, créant ainsi des secondes ouvertures via (35) qui exposent les structures de grille (4, 3) du second type,
- remplissant les secondes ouvertures via (35) et les secondes tranchées approfondies (29') avec un matériau électriquement conducteur (36), pour obtenir ainsi les secondes connexions via (38),
- planarisant ledit matériau électriquement conducteur et la seconde couche diélectrique (26) pour obtenir ainsi les secondes lignes conductrices (39) intégrées dans la seconde couche diélectrique planarisée (26).

3. Procédé selon la revendication 1 ou 2, dans lequel la couche de grille est une seule couche de matériau de grille de façon à ce que les portions masques (3', 4') soient formées directement sur les structures de grille respectives (3, 4) formées uniformément dudit matériau de grille.

4. Procédé selon la revendication 1 ou 2, dans lequel la couche de grille comprend une couche inférieure formée d'un premier matériau de grille et une couche supérieure directement sur la couche inférieure et formée d'un second matériau de grille, de façon à ce que les portions masques (3', 4') soient formées directement sur les structures de grille respectives formées d'un empilement d'une portion grille inférieure (3a, 4a) du premier matériau de grille et d'une portion grille supérieure (3b, 4b) du second matériau de grille sur la première portion grille, et dans lequel :
- la formation des premières ouvertures via (15) inclut le retrait d'au moins une partie des portions grilles supérieures (3b, 4b) des structures de grille du premier type par rapport aux portions grilles inférieures (3a, 4a),
- la formation des secondes ouvertures via (35) inclut le retrait d'au moins une partie de la portion masque dur (4', 3') sur les structures de grille du second type sans retirer les portions grilles supérieures (4b, 3b) des structures de grille du second type.

5. Procédé selon l'une quelconque des revendications précédentes, dans lequel les dimensions latérales des structures de grille (3, 4) et l'espacement entre les structures de grille adjacentes sont compris entre 5 et 50 nm et dans lequel l'épaisseur de la couche conforme (25) est comprise entre 1 et 5 nm.

6. Procédé selon l'une quelconque des revendications précédentes, dans lequel le matériau des portions masques durs (3', 4') est du nitrure de silicium, et dans lequel la couche conforme (25) comprend au moins une couche supérieure formée de carbonate de silicium.

7. Procédé selon l'une quelconque des revendications 4 à 6, dans lequel le second matériau de grille est un métal.

8. Dispositif à points quantiques à qubits de spin comprenant :
- un réseau de structures de grille (3, 4) agencées alternativement d'un premier et d'un second type agencées dans une direction longitudinale sur une surface plane (1),
- des premières connexions via (18) aux structures de grille (3) du premier type, lesdites premières connexions via étant connectées à des premières lignes conductrices respectives (17) s'étendant essentiellement parallèlement à ladite surface plane (1),
- des secondes connexions via (38) aux structures de grille (4) du second type, lesdites secondes connexions via étant connectées à des secondes lignes conductrices respectives (39) s'étendant essentiellement parallèlement à ladite surface plane (1),
dans lequel les premières et les secondes lignes conductrices (17, 39) sont intégrées dans une couche (26') de matériau diélectrique, ladite couche comprenant des entretoises sur les parois latérales des premières lignes conductrices (17).

9. Dispositif selon la revendication 8, dans lequel les dimensions latérales des structures de grille (3, 4) et l'espacement entre les structures de grille adjacentes sont compris entre 5 et 50 nm et dans lequel l'épaisseur des entretoises est comprise entre 1 et 5 nm.
